# EUROPÄISCHE PATENTSCHRIFT

(11) **EP 2 738 800 B1**
(45) Veröffentlichungstag und Bekanntmachung des Hinweises auf die Patenterteilung: **17.01.2018**
(21) Anmeldenummer: 13182932.7
(22) Anmeldetag: 04.09.2013
(51) Int. Cl.: H01L 23/34, H01L 33/64, H02S 40/42, F28F 3/12, F28F 13/00, H01L 23/473

(54) **System zur Temperierung von elektronischen oder optoelektronischen Bauelementen oder Baugruppen**
System for tempering electronic or optoelectronic components or component groups
Système de régulation de la température d'éléments de construction ou de modules de construction électroniques ou optoélectroniques

(30) Priorität: 18.09.2012 DE 102012018738; 03.01.2013 DE 102013000213
(43) Veröffentlichungstag der Anmeldung: 04.06.2014
(73) Patentinhaber: Glatt Systemtechnik GmbH, 01277 Dresden (DE)
(72) Erfinder: Hungerbach, Wolfgang, 79379 Müllheim (DE); Bäuerle, Armin, 79379 Müllheim (DE)
(74) Vertreter: Pfenning, Meinig & Partner mbB

(56) Entgegenhaltungen:
- EP-A1- 0 559 092
- DE-A1- 10 352 711
- GB-A- 2 404 009
- US-A- 6 016 007
- US-A1- 2003 230 401
- US-A1- 2005 111 188
- US-A1- 2010 328 888

## Beschreibung

Die Erfindung betrifft ein System zur Temperierung von elektronischen oder optoelektronischen Bauelementen oder Baugruppen. Bei den elektronischen oder optoelektronischen Bauelementen kann es sich bevorzugt um elektromagnetische Strahlung emittierende oder für diese Strahlung sensitive Elemente, wie dies beispielsweise Licht emittierende Dioden (LED's, OLED's), Photodetektoren oder photovoltaische Elemente sind, handeln. Ein Einsatz ist insbesondere sinnvoll, wenn diese Bauelemente innerhalb eines Temperaturbereichs einen verbesserten Wirkungsgrad aufweisen, der eingehalten werden sollte oder wenn die Verlustleistung der Bauelemente so hoch ist, dass eine Gefahr einer zerstörend wirkenden Übergangstemperatur besteht.

Überwiegend ist bei der Temperierung eine Kühlung erforderlich. So ist es bei den in jüngerer Vergangenheit entwickelten und zum Einsatz kommenden Hochleistungs-LED's so, dass sich diese während des Betriebes erheblich erwärmen, was aber zu einer Reduzierung des effektiven Wirkungsgrades führt.

Ähnlich verhält es sich bei photovoltaischen Bauelementen, die sich in Folge einer hohen Sonnenstrahlung sehr stark erwärmen können. Dadurch kann es zu Beschädigungen oder zu einer Einschränkung der Lebensdauer bzw. Standzeit dieser Anlagen kommen, so dass auch hier eine Kühlung als eine Form der Temperierung erforderlich ist.

In anderen Fällen kann es erforderlich sein, eine Erwärmung auf eine bestimmte erforderliche bzw. günstige Betriebstemperatur durchzuführen.

Üblicherweise wird für solche Temperierungen ein Temperaturfluid eingesetzt, das gasförmig oder flüssig sein kann. In der Regel sind dies aus Kostengründen Luft oder Wasser. Die Wärmeübertragung erfolgt dabei von einer Oberfläche auf das jeweilige Fluid, während das Fluid entlang der Oberfläche strömt. Auch wenn eine turbulente Strömung erfolgt, sind hier Grenzen gesetzt. Außerdem erfolgt die Wärmeübertragung proportional zur jeweiligen nutzbaren Oberfläche, an der das jeweilige Fluid entlang strömen kann. Bei den bekannten technischen Lösungen sind hier Grenzen gesetzt. Bei großen ausnutzbaren Oberflächen ist ein großes Volumen erforderlich und es erhöht sich dadurch auch die Masse.

So betrifft US 2010/0328888 ein Kühlsystem, das einen Metallschaum nutzt, durch den ein Kühlmittel strömt. Dabei soll ein komprimiertes Kühlmittel über Leitungen zu Düsen geführt werden und dort auf eine zu kühlende Oberfläche auftreffen. Anschließend verdampft das expandierte Kühlmittel und wird als Dampf über den Metallschaum abgeführt.

EP 0 559 092 betrifft ebenfalls den Einsatz eines Metallschaumes zu Kühlzwecken.

Aus US 2003/0230401 ist lediglich der allgemeine Einsatz eines Temperatursensors zur Regelung zu entnehmen.

Ein Bauteil zur Dampfkühlung elektronischer Elemente ist in GB 2 404 009 A beschrieben.

DE 103 52 711 A1 betrifft eine Leiterplatte , die mittels Metallschaum gekühlt werden kann.

Ein Temperaturmanagmentsystem für integrierte Schaltungen ist in US 2005/0111188 A1 offenbart.

US 6,016,007 B betrifft eine Kühlung für elektronische Elemente.

Es ist daher Aufgabe der Erfindung, ein System zur Temperierung zur Verfügung zu stellen, mit dem eine Temperierung effektiv erreicht werden kann, das einen geringen Herstellungsaufwand erfordert und das eine verringerte Eigenmasse und ein geringes erforderliches Bauvolumen aufweist.

Erfindungsgemäß wird diese Aufgabe mit einem System, das die Merkmale des Anspruchs 1 aufweist, gelöst. Vorteilhafte Ausgestaltungen und Weiterbildungen der Erfindung können mit in untergeordneten Ansprüchen bezeichneten Merkmalen realisiert werden.

Ein erfindungsgemäßes System weist ein Wärmetauscherelement auf, das von einem Temperierfluid durchströmt werden kann. Das Wärmetauscherelement ist dabei als ein offenporiger metallischer Körper ausgebildet an dem mindestens eine Oberfläche des Körpers, die in Richtung mindestens eines elektronischen oder optoelektronischen Bauelements oder einer solchen Baugruppe ausgerichtet ist, fluiddicht ausgebildet oder mit einer für das Temperierfluid dichten Beschichtung versehen ist.

Das Wärmetauscherelement sollte eine Porosität von mindestens 70 %, bevorzugt mindestens 90 % und/oder Porengrößen im Bereich 300 µm bis 700 µm aufweisen. Dadurch kann eine ausreichende Durchströmbarkeit des Temperierfluids gewährleistet werden. Außerdem steht für die Wärmeübertragung auf das Temperierfluid bei einer Kühlung oder vom Temperierfluid bei einer Erwärmung eine vergrößerte Oberfläche zur Verfügung. Das Wärmetauscherelement ist dabei außerdem gut wärmeleitend, so dass eine gute Wärmeübertragung in Richtung des jeweiligen Temperaturgradienten über den metallischen Werkstoff, aus dem das Wärmetauscherelement gebildet ist, ausgenutzt werden kann.

Durch die relativ großen Hohlräume innerhalb des Wärmetauscherelements ist seine Eigenmasse relativ gering.

Bevorzugt ist das Wärmetauscherelement aus einem Metallschaum gebildet. Es kann aber auch mit mehreren metallischen Körpern, bevorzugt Hohlkörpern, die in loser Schüttung innerhalb eines Gehäuses aufgenommen oder stoffschlüssig miteinander verbunden sind, gebildet sein.

In beiden Fällen kann bei geringer Eigenmasse auch eine relativ hohe mechanische Festigkeit erreicht werden, so dass ein Wärmetauscherelement auch eine tragende Funktion ausüben kann. Außerdem wirkt es schalldämmend, was auch vorteilhaft ist bzw. sein kann.

Ein solches metallisches Wärmetauscherelement kann in den verschiedensten geometrischen Formen oder Dimensionierungen allein durch die einsetzbaren Herstellungsverfahren in lediglich einem oder sehr wenigen Verfahrensschritten hergestellt werden. Dabei kann die Form ohne eine erforderliche mechanische Nachbearbeitung erhalten werden.

Ein Metallschaum kann auf an sich bekannte Art und Weise pulvermetallurgisch hergestellt werden. Dabei wird ein polymerer offenporiger Schaumkörper an seiner Oberfläche mit einem Metallpulver und einem Binder in Form einer Suspension beschichtet. Bei einer Wärmebehandlung werden die organischen Komponenten, bevorzugt durch Pyrolyse, zuerst entfernt und anschließend erfolgt bei höheren Temperaturen eine Sinterung, so dass ein metallischer Schaumkörper erhalten werden kann. Seine Porosität und die Porengrößen können mit dem eingesetzten polymeren Schaumkörper und dem jeweiligen Metallpulver, was seine chemische Zusammensetzung und Partikelgröße betrifft, gezielt beeinflusst werden.

Wird ein Wärmetauscherelement mit Körpern gebildet, sollten wegen der entsprechend großen Oberfläche kugelförmige Körper eingesetzt werden. Wegen eines gewünschten Leichtbaus können Hohlkörper das Wärmetauscherelement bilden. Möglichkeiten für die Herstellung solcher Hohlkörper sind aus dem Stand der Technik bekannt.

Die Körper können stoffschlüssig miteinander verbunden sein, was durch Kleben, Löten oder miteinander Versintern erreichbar ist. So kann auch eine bestimmte Geometrie und Dimensionierung eingehalten werden.

Die Körper können gleiche äußere Abmessungen aufweisen. Es besteht aber auch die Möglichkeit Körper mit unterschiedlichen äußeren Abmessungen einzusetzen.

Es kann auch eine Beeinflussung der Porosität und/oder die Porengröße innerhalb des Volumens ausgenutzt werden. So kann sich die Porosität und/oder Porengröße ausgehend von der Seite des Wärmetauscherelements, die in Richtung zu temperierender elektronischer oder optoelektronischer Bauelemente weist, sukzessive oder kontinuierlich vergrößern, wenn in ihren äußeren Abmessungen unterschiedlich dimensionierte Körper entsprechend innerhalb des Volumens eines Wärmetauscherelements angeordnet werden. Dies ist aber auch mit einem Metallschaum möglich. Bei einem Metallschaum kann eine sukzessive Vergrößerung durch übereinander Anordnung unterschiedlicher Metallschäume erreicht werden. Bei einer kontinuierlichen Vergrößerung kann ein entsprechend ausgebildeter polymerer Schaumkörper als Vorprodukt eingesetzt werden.

Bei einer so veränderten Porosität und/oder Porengrößere ist im Bereich nahe zu mindestens einem zu temperierenden Bauelement, der Anteil an Metall innerhalb des Volumens größer, als das hohle Volumen, durch das Temperierfluid strömen kann. Dadurch kann die verbesserte Wärmeleitung des Metalls besser ausgenutzt werden.

Eine entsprechende Vergrößerung der Porosität und/oder Porengrößen kann aber auch allein oder zusätzlich in oder entgegengesetzt zur Strömungsrichtung des Temperierfluids durch das Wärmetauscherelement gewählt werden. Dadurch kann die Verweilzeit des Temperierfluids und dabei auch die Wärmeübertragung zwischen Temperierfluid und Metall während des Durchströmens innerhalb des Volumens lokal definiert beeinflusst werden.

Die fluiddichte Oberfläche eines Wärmetauscherelements kann direkt bei der Herstellung eines Metallschaums durch entsprechend verstärkten Pulverauftrag, das Auflegen eines dünnen plattenförmigen Elements aus Metall, das mit dem Metallschaum, beispielsweise bei der Sinterung über Sinterbrücken miteinander verbunden werden kann, ausgebildet werden.

Eine fluiddichte Schicht kann beispielsweise mit einer elektrisch leitenden und an sich bekannten Lötfolie ausgebildet werden. Eine Lötfolie kann dabei auf die entsprechende Oberfläche des Wärmetauscherelements aufgelegt und bei einem Wärmeeintrag mit dem Wärmetauscherelement an einer Seite sowie ggf. an der anderen Seite mit einem anderen Element oder mindestens einem Bauelement bzw. einem Träger eines Bauelements verbunden werden.

Für eine fluiddichte Schicht, die elektrisch nicht leitend ist, kann keramisches Pulver eingesetzt werden, das wie das Metallpulver vorab beschrieben, an der Oberfläche mit einem Binder aufgetragen und dann dicht gesintert wird. Für die Ausbildung einer solchen Schicht kann auch ein Glaslot eingesetzt werden, wie es für die Herstellung von Hochtemperaturbrennstoffzellen bereits seit längerer Zeit eingesetzt wird. Ein Glaslot ist nicht nur elektrisch isolierende und für ein Fluid dicht, es kann auch für elektromagnetische Strahlung transparent sein.

Für die Herstellung eines Wärmetauscherelements kann als Metall Fe, Ni, Al oder Cu bzw. eine Legierung eines dieser Metalle eingesetzt werden. Die Auswahl kann unter Berücksichtigung der Einsatzbedingungen erfolgen. So besteht die Möglichkeit eine Optimierung in Richtung Wärmeleitung vorzusehen. Es kann aber auch ein Kompromiss zwischen Wärmeleitvermögen und mechanischer Festigkeit, chemischer oder Korrosionsbeständigkeit getroffen werden. So kann beispielsweise ein Wärmetauscherelement auch aus einem Stahl hergestellt sein.

Bei der Erfindung besteht die Möglichkeit, zumindest den Oberflächenbereich des Wärmetauscherelements, der nicht in Richtung elektronischer oder optoelektro-nischer Bauelemente weist, von einer thermischen Isolation zu umschließen. Dadurch kann die Erwärmung nach außen in Richtung Umgebung reduziert werden und die Temperierung wird so nahezu ausschließlich mittels des Temperierfluids erreicht. Ein Wärmetauscherelement kann auch in einem Gehäuse aufgenommen sein, das bevorzugt für elektromagnetische Strahlung transparent ist.

Es kann mindestens jeweils ein Zufluss und ein Abfluss für ein Temperierfluid und/oder ein Temperatursensor für eine Regelung des Volumenstroms des durch das Wärmetauscherelement strömenden Temperierfluids vorhanden sein. Das Temperierfluid kann dabei durch das Wärmetauscherelement strömen während an einer geeigneten Position mit einem Temperatursensor die Temperatur gemessen wird. Dies kann beispielsweise unmittelbar an einer Oberfläche des Wärmetauscherelements erfolgen. Mit dem mindestens einen Temperaturmesssignal kann dann eine Pumpe oder ein Ventil angesteuert werden, um den durch das Wärmtauscherelement geführten Volumenstrom an Temperierfluid zu regeln. Das Temperierfluid kann im Kreislauf über einen weiteren Wärmetauscher geführt werden, in dem es auf eine für die Temperierung geeignete Temperatur gekühlt oder ggf. auch erwärmt wird.

Bei dem erfindungsgemäßen System besteht die Möglichkeit, eine Integration verschiedenster Elemente vorzunehmen, um einen kompakten Aufbau, einen Schutz von Elementen vor äußeren betriebsbedingten und Umwelteinflüssen zu gewähren.

Insbesondere wenn ein Wärmetauscherelement aus einem Metallschaum gebildet ist, kann der Einfluss von Temperaturschwankungen, die zu einer Veränderung der äußeren Abmessungen führen, durch ein gewisses aber ausreichendes Maß an Kompressibilität des Metallschaums, bei einer Erwärmung, ohne weiteres kompensiert werden.

Vorteilhaft können Sensoren, Aktoren oder elektrisch leitende Verbindungen innerhalb des Systems integriert vorhanden sein. Diese Elemente können dabei in einem Bereich angeordnet sein, der mit in eine polymere Matrix eingebetteten Hohlkörpern gebildet ist. Dadurch können komplexe Geoemtrien, die auch an die Erfordernisse der jeweiligen Temperierung bzw. an zu temperierende Bauelemente angepasst werden können, einfach realisiert werden. Der Montageaufwand lässt sich so weiter reduzieren.

Dabei können beispielsweise Verbindungsleitungen für Medien, Messignale oder die Energieversorgung, wie verschiedenste Sensoren bei der Erfindung so angeordnet sein.

So besteht beispielsweise die Möglichkeit einen optischen Sensor, der mit mindestens einem Lichtwellenleiter, einer Lichtquelle und einem Detektor gebildet ist, zu integrieren. Das durch den Lichtwellenleiter geführte Licht, kann durch äußere Einflüsse beeinflusst und diese Veränderung mit dem Detektor dann erfasst und ausgewertet werden. Ein äußerer Einfluss kann dabei zur Zerstörung des Lichtwellenleiters oder zu seiner Verbiegung führen, was wiederum ein verändertes Messsignal am Detektor bewirkt, das ausgewertet und genutzt werden kann. So kann beispielsweise eine Verbiegung des Lichtwellenleiters, bevorzugt wenn dieser als Faser ausgebildet ist, die durch äußere Einflüsse, aber auch bei sich verändernden Temperaturen auftreten kann, berücksichtigt werden. Dies kann für ein Notabschalten oder eine Regelung der Temperierung genutzt werden.

Bei der Erfindung besteht außerdem die Möglichkeit, die mechanische Festigkeit und Stabilität des Systems in einfacher Form und kostengünstig zu erhöhen. Hierfür können am/im Wärmetauscherelement, einem thermischen Isolierelement, einem Gehäuse und/oder einem Bereich, der mit eingebetteten Hohlkörpern gebildet ist, Verstärkungselemente, bevorzugt in Form von Textilien oder Stäben, angeordnet sein. Textilien können dabei Matten in Form von Geweben, Gewirken oder in anderer Form ausgebildeten Faserstrukturen aus den unterschiedlichen Materialien, wie. Z.B. Glasfasern hergestellt sein. Stäbe können für eine Verstärkung, in einer oder mehreren Vorzugsrichtungen ausgerichtet, angeordnet werden.

Bei dem erfindungsgemäßen System ist es besonders bevorzugt, dass mindestens ein elektronisches oder optoelektronisches Bauelement unmittelbar auf der Oberfläche des Wärmetauscherelements oder der für das Temperierfluid dichten Beschichtung angeordnet ist. Dadurch kann di gewünschte Temperierung deutlich verbessert werden, da die Verhältnisse für die Wärmeleitung so besonders günstig sind. Eine solche Anordnung bietet sich beispielsweise bei elektronischen oder optoelektronischen Bauelementen an, die bei ihrem Betrieb besonders temperaturempfindlich sind und eine bestimmte Maximal- oder Minimaltemperatur nicht über- bzw. unterschreiten dürfen. Dies betrifft z.B. Hochleistungs-LED's. Dabei können so genannte Wärmebrücken vermieden oder deren Wirkung reduziert werden.

Bei der Erfindung besteht auch die vorteilhafte Möglichkeit, am Wärmetauscherelement oder dem Gehäuse für das Wärmetauscherelement einen elektrischen Transformator (Netzteil) oder einen Gleichrichter anzuordnen oder dort zu befestigen, so dass ein Transformator/Gleichrichter ebenfalls mit dem Wärmetauscherelement temperiert werden kann.

Bei vielen Einsatzfällen kann es vorteilhaft sein, in das Wärmetauscherelement mindestens ein Strömungsführungselement für das Temperierfluid zu integrieren. Mit diesen Strömungsführungselement(en) kann der Weg, den das Temperierfluid auf dem Weg von seinem Zufluss bis zu seinem Abfluss zurück legt, beeinflusst werden. Die Strömung des Temperierfluids kann dabei die Anordnung elektronischer oder optoelektronischer Bauelemente berücksichtigen.

Auch die Anordnung und Ausbildung von Strömungsführungselementen im Wärmetauscherelement sollte die Anordnung elektronischer oder optoelektronischer Bauelemente berücksichtigen. Sie sollten in diesen Bereichen keinen Wärmebrückeneffekt hervorrufen und beispielsweise in einem Abstand zu einem elektronischen oder optoelektronischen Bauelement angeordnet sein. Die Strömungsführungselemente können auch aus einem Werkstoff mit geringer Wärmeleitfähigkeit, beispielsweise Keramik gebildet sein.

Sie können für das Temperierfluid eine Barriere in Bereichen darstellen und so dessen Strömungsrichtung gezielt beeinflussen. Dabei kann auch ein gegenüber dem Abstand zwischen Zu- und Abfluss verlängerter Weg den das Temperierfluid innerhalb des Wärmetauscherelements zurück legen muss, erreicht werden. Es besteht dadurch außerdem die Möglichkeit, die Verweilzeit des Temperierfluids in kritischen Bereichen zu erhöhen, so dass das Temperierfluid dort mehr Wärme aufnehmen oder bei einer Kühlung abgeben kann. Der Einsatz von Strömungsführungselementen bietet sich besonders bei Wärmetauscherelementen, die als Metallschaum ausgebildet sind, an.

Strömungsführungselemente sollten dabei keine Wärmebrücken zu einem Deckelelement, einem fluiddichten Bereich oder eines solchen Beschichtung aufweisen. Sie können entsprechend dimensioniert sein und beispielsweise von einer Seite des Wärmetauscherelements in Richtung der gegenüberliegenden Seite geführt sein und dabei eine Länge aufweisen, die nicht bis zu einem Deckelelement, einem fluiddichten Bereich oder einer solchen Beschichtung reicht.

Strömungsführungselemente können so angeordnet sein, dass der Weg, den das Temperierfluid zurück legt, beeinflusst wird und dies nicht der kürzeste Weg zwischen Zu- und Abfluss ist.

Dadurch kann zusätzlich die ohnehin gegenüber dem Stand der Technik verbesserte Homogenität der Temperaturverteilung über die gesamte Fläche des Wärmetauscherelements, die zur Temperierung genutzt werden kann, noch weiter verbessert werden.

Es besteht auch die Möglichkeit, dass mindestens ein elektronisches oder optoelektronisches Bauelement ein Deckelelement bildet oder an einem Deckelelement befestigt ist. Ein Deckelelement kann dann unmittelbar auf eine Oberfläche des Wärmetauscherelements aufliegen oder dort angeordnet sein.

Ein Deckelelement kann mit einem Gehäuse oder dem Wärmetauscherelement verbunden werden. Hierfür bieten sich ein Schweißverfahren, eine Löt-, Kleb- oder Schraubverbindung an. In jedem Fall sollte ein geringer Wärmeeintrag bei der Herstellung der Verbindung erfolgen. So kann eine Schweißverbindung mittels Laserschweißen und eine Lötverbindung mit einem niedrig schmelzenden Lot ausgebildet werden. Der Wärmeeintrag sollte so klein sein, dass das/die elektronische(n) oder optoelektronische(n) Bauelement(e) nicht beeinträchtigt wird/werden.

Da es für verschiedene Anwendungen erforderlich sein kann, große Temperaturdifferenzen berücksichtigen zu können und insbesondere große Wärmemengen abzuführen, kann es erforderlich sein ein, Temperierfluid mit hohem Volumenstrom und unter erhöhtem Druck stehend, wobei Drücke von ca. 6 bar auftreten können, durch das Wärmetauscherelement zu führen. Hierfür sollte ein Deckelelement, ein fluiddichter Bereich oder eine solche Beschichtung eine entsprechende Festigkeit aufweisen. Dies kann beispielsweise, wie nachfolgend noch beschrieben, mittels mindestens eines Versteifungselements erreicht werden.

Insbesondere bei großen Volumenströmen oder hohen Drücken mit denen das Temperierfluid durch ein Wärmetauscherelement hindurchgeführt wird, kann es vorteilhaft sein, durch das Wärmetauscherelement, ausgehend von der Oberfläche an der mindestens ein elektronisches oder optoelektronisches Bauelement angeordnet ist, bis zu der dieser Oberfläche gegenüberliegenden Oberfläche mindestens ein Versteifungselement geführt ist. Ein oder mehrere Versteifungselement(e) kann/können innen hohl sein. So kann beispielsweise durch ein rohrförmiges Versteifungselement eine elektrische oder elektronisch leitende Verbindung durch das Wärmetauscherelement hindurchgeführt werden. Günstig ist es auch, wenn das/die Versteifungselement(e) mit dem Deckelelement verbunden ist/sind. Die Verbindung kann dabei bevorzugt kraft- und/oder formschlüssig sein, wodurch keine Wärme eingetragen werden muss. So kann beispielsweise ein Versteifungselement eingesetzt werden, dass bei der Montage an mindestens einer Stirnseite aufgeweitet wird, so dass eine Pressverbindung hergestellt werden kann.

Als Temperierfluid können beispielsweise Wasser, Luft, ein Gas, Glykol oder ein Gemisch davon eingesetzt werden.

Es besteht außerdem die Möglichkeit, zur Ausrichtung oder Justierung elektronischer oder optoelektronischer Bauelemente mindestens ein Fixierelement vorzusehen. Ein oder mehrere Fixierelemente können an einem Gehäuse befestigt sein. Damit kann mindestens ein elektronisches oder optoelektronisches Element allein oder gemeinsam als Einheit mit dem Wärmetauscherelement in eine gewünschte Richtung ausgerichtet werden, so dass beispielsweise eine Justierung in eine horizontale Lage oder die Einstellung eines gewünschten Neigungswinkels möglich ist. Dafür sollte mindestens ein Fixierelement so ausgebildet sein, dass eine Höhenverstellbarkeit erreicht werden kann. Dies kann beispielsweise durch gezielte Verdrehung eines Exzenters erreicht werden. Das mindestens eine elektronische oder optoelektronische Bauelement kann dann allein oder gemeinsam mit dem Wärmetauscherelement auf mindestens zwei starren Halterungen aufliegen.

Das eine Fixierelement oder mehrere Fixierelemente bzw. Halterungen sollten in gleichen Winkelabständen über den Umfang bzw. den äußeren Rand verteilt angeordnet sein.

Ein erfindungsgemäßes System kann selbstragend und im Leichtbau ausgebildet werden. Während der Nutzung und dabei auch bei sich verändernden Temperaturen tritt zumindest nahezu kein Verzug auf.

Es besteht die Möglichkeit, Komponenten, wie z.B. Sensoren, Aktoren, elektrische Komponenten oder für die Kommunikation nutzbare Elemente bzw. Komponenten in eingebetteter Form sicher und geschützt aufzunehmen.

Es ist ein verbesserter Schutz gegen Umwelt- oder Umgebungseinflüsse, wie Witterung, Korrosion und mechanischen Angriff erreichbar.

Ebenfalls kann eine einfache Anpassung an äußere geometrische Verhältnisse für einen optimalen Ein- oder Anbau in Anlagen oder Komponenten erfolgen, um eine optimale Raumausnutzung zu ermöglichen.

Für bzw. nach einer Montage ist keine mechanische Nachbearbeitung am System oder einzelner Komponenten des Systems, wie z.B. das Gehäuse, die thermische Isolation oder auch des Wärmetauscherelements mehr erforderlich.

Außerdem besteht die Möglichkeit, ein oder mehrere erfindungsgemäße System(e) mit weiteren anders konfigurierten Systemen oder Anlagenkomponenten oder mehrere gleiche bzw. gleichartige erfindungsgemäße Systeme untereinander oder miteinander zu kombinieren.

Nachfolgend soll die Erfindung beispielhaft näher erläutert werden.

Dabei zeigen:

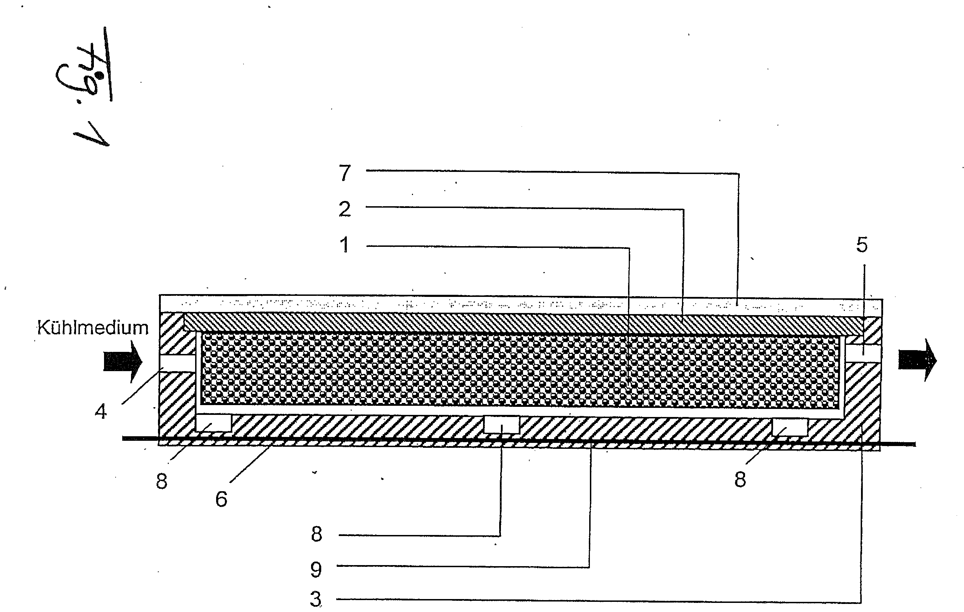

Figur 1 in schematischer Form ein Beispiel eines erfindungsgemäßen Systems;
Figur 2 in schematischer Form ein weiteres Beispiel in einer Schnittdarstellung;
Figur 3 eine Schnittdarstellung mit einem Deckelelement, das an einem Gehäuse für ein Wärmetauscherelement befestigt ist und
Figur 4 einen Schnitt durch eine Draufsicht auf ein Beispiel eines erfindungsgemäßen Systems mit Strömungsführungselementen.

Dabei ist ein Wärmetauscherelement 1 aus einem aus einem korrosionsfesten Eisen-Chromstahl gebildeten Metallschaum innerhalb eines Gehäuses 6 angeordnet. Zwischen dem Gehäuse 6 und dem Wärmetauscherelement 1 ist eine thermische Isolation 3 vorhanden.

Der Metallschaum hat eine Porosität von 96 % und eine mittlere Porengröße von 650 µm. Seine Länge ist in Strömungsrichtung von Wasser als Temperierfluid mehrfach, bevorzugt mindestens dreifach größer als seine Dicke in senkrechter Richtung dazu. Die Strömungsrichtung ist durch den Zufluss 4 und den Abfluss 5 vorgegeben. In der Darstellung oberhalb des Wärmetauscherelements 1 ist ein photovoltaisches Element (Solarzellenpaneel) als optoelektronisches Bauelement 2 angeordnet, das mit dem System durch Kühlung temperiert werden kann.

Oberhalb des photovoltaischen Bauelements 2 ist eine Glasscheibe 7 als optisch transparente Abdeckung und Schutzelement angeordnet.

Bei dem gezeigten Beispiel sind auch Hohlräume 8 vorhanden, die hier unmittelbar unterhalb des Wärmetauscherelements 1 angeordnet und ausgebildet sind. In den Hohlräumen 8 können verschiedene Komponenten und Elemente, wie z.B. Sensoren, Aktoren, elektrisch leitende Verbindungen untergebracht und im System unmittelbar integriert werden. Hohlräume 8 können aber auch an anderen Positionen angeordnet sein. So kann mindestens ein Hohlraum auch innerhalb des Wärmetauscherelements 1 und darin wiederum ein Sensor oder ein Aktor angeordnet sein. Mit einem Sensor kann beispielsweise die Temperatur gemessen werden. Mit einem aktiv beeinflussbaren Aktor kann beispielsweise der Strömungswiderstand für das Temperierfluid variiert und damit auch gezielt Einfluss auf die Temperierung in geregelter oder gesteuerter Form genommen werden.

Im Inneren kann aber neben elektrischen Leitern auch mindestens ein optischer Lichtwellenleiter 9 vorgesehen sein, mit dem die Erkennung von Schäden, beispielsweise durch mechanische oder thermische Einflüsse möglich ist.

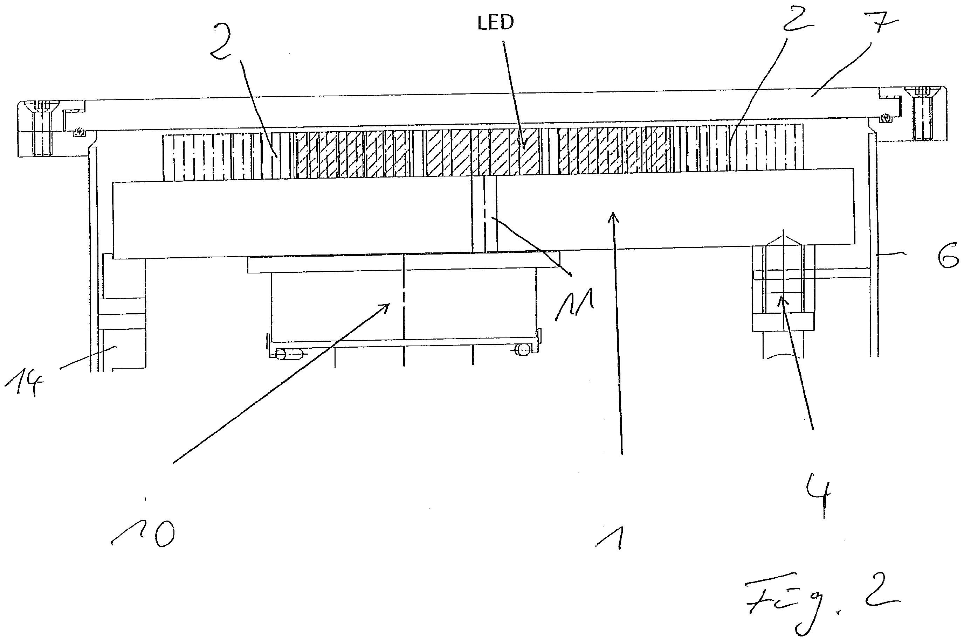

In Figur 2 ist ein weiteres Beispiel eines erfindungsgemäßen Systems gezeigt. Dabei ist ein ebenfalls als Metallschaum ausgebildetes Wärmetauscherelement 1 in einem Gehäuse 6 angeordnet. Auf der Oberfläche des Wärmetauscherelements 1 sind unmittelbar elektronische oder optoelektronische Elemente 2 angeordnet, so dass diese in unmittelbarem Kontakt mit dem Wärmetauscherelement 1 stehen.

Diese Einheit, die mit elektronischen oder optoelektronischen Elementen 2 und dem Wärmetauscherelement 1 gebildet ist, ist bei diesem Beispiel mit Fixierelementen 14 am Gehäuse 6 gehalten. Die Fixierelemente 14 sind dabei so ausgebildet, dass die Ausrichtung dieser Einheit eingestellt werden kann. So kann eine horizontale Ausrichtung justiert oder eine gewünschte Winkelneigung eingestellt werden kann. So können beispielsweise lichtemittierende Bauelemente in einem schräg geneigten Winkel ausgerichtet werden, so dass Licht in dem entsprechenden Winkel abgestrahlt werden kann. Als Fixierelement 14 können beispielsweise Exzenter eingesetzt werden. So kann ein solches Fixierelement 14 vorhanden sein und eine Einheit ansonsten auf mindestens zwei weiteren starren Halterungen aufliegen oder daran starr befestigt sein. Es können aber auch mehrere Fixierelemente 14, mit denen eine Justierung oder Einstellung des Neigungswinkels möglich ist, vorhanden sein, die über den Umfang oder den äußeren Rand verteilt angeordnet sind.

Am Wärmetauscherelement 1 ist bei diesem Beispiel ein Transformator 10 befestigt, mit dem eine für den Betrieb elektronischer oder optoelektronischer Elemente 2 geeignete elektrische Spannung zur Verfügung gestellt werden kann. Dieser Transformator 10 kann ebenfalls mit dem durch das Wärmetauscherelement 1 hindurch geführten Temperierfluid temperiert werden. Das Temperierfluid tritt durch den Zufluss 4 ein und durch den hier nicht dargestellten Abfluss 5 wieder aus.

Durch das Wärmetauscherelement 1 ist von seiner Rückseite ein Rohr als Versteifungselement 11 geführt. Dieses Versteifungselement 11 kann auf Zugkräfte beansprucht werden und dadurch Verformungen infolge erhöhter Drücke im Inneren des Wärmetauscherelements 1 vermeiden helfen. Durch das Innere des Versteifungselements 11 können beispielsweise elektrische Leiter vom Transformator 10 bis zu den elektronischen oder optoelektronischen Elementen 2 geführt sein.

Von oben ist das Gehäuse 6 mit der Einheit mit einer Glasscheibe 7 abgedeckt und geschützt.

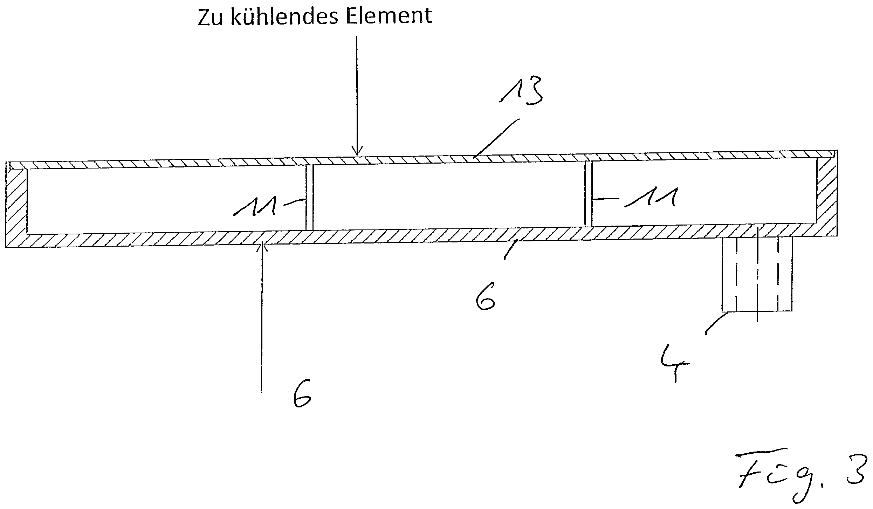

Figur 3 zeigt eine Schnittdarstellung mit einem Deckelelement 13, das an einem Gehäuse 6 für ein Wärmetauscherelement 1 befestigt ist. Bei diesem Beispiel sind Versteifungselemente 11, die an einer Seite mit dem Gehäuse 6 und an der gegenüber liegenden Seite mit einem Deckelelement 13 verbunden und durch das Wärmetauscherelement 1 hindurch geführt sind, vorhanden. Das Deckelelement 13 ist dabei mit mindestens einem elektronischen oder optoelektronischen Bauelement 2 gebildet. Es liegt direkt auf der Oberfläche des Wärmetauscherelements 1 auf, so dass eine nahezu ungehinderte Wärmeleitung erreicht werden kann.

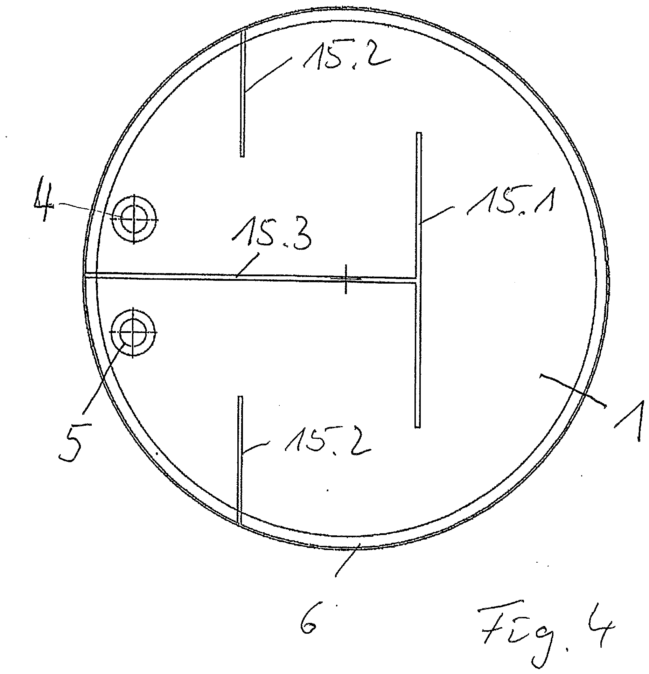

In Figur 4 ist eine Schnittdarstellung einer Draufsicht durch ein Beispiel eines erfindungsgemäßen Systems gezeigt. Dabei ist ein Wärmetauscherelement 1 in einem rotationssymmetrischen Gehäuse 6 aufgenommen. Temperierfluid kann durch einen Zufluss 4 in das Wärmetauscherelement 1 ein- und durch den Abfluss 5 wieder herausströmen. Im Wärmetauscherelement 1 sind bei diesem Beispiel drei Strömungsführungselemente 15.1 und 15.2 aufgenommen. Diese sind so angeordnet bzw. ausgerichtet, dass das Temperierfluid einen definierten Weg durch das Wärmetauscherelement 1 hindurch zurück legen muss. Die Strömungsrichtung wird dabei mehrfach verändert. Dadurch ist es noch besser möglich, eine homogene Temperaturverteilung ohne Temperaturspitzen (z.B. hot spots) im Bereich eines Deckelelements 13 oder dem Bereich, in dem elektronische oder optoelektronische Bauelemente 2 angeordnet sind, zu erreichen.

Besonders vorteilhaft ist es dabei, wenn die Strömungsführungselemente 15.1 und 15.2 nicht vollständig durch das gesamte Wärmetauscherelement 1 von einer Seite bis zur gegenüberliegenden Seite geführt sind. So sollte ein Wärmebrückeneffekt in Richtung der elektronischen oder optoelektronischen Bauelemente 2 vermieden werden können, wenn die Strömungsführungselemente 15.1 und 15.2 keinen direkten Kontakt zu einem Deckelelement 13 oder einer fluiddichten Beschichtung oder eines fluiddichten Bereichs des Wärmetauscherelements 1 aufweisen.

Die Strömungsführungselemente 15. 1 oder 15.2 können beispielsweise Bleche oder andere plattenförmige Elemente sein. Diese können in einen Metallschaum eingebettet sein, was bereits bei der Herstellung des Metallschaums erreicht werden kann. Dabei können die Strömungsführungselemente 15.1 und 15.2 innerhalb eines Formwerkzeugs mit eingeschäumt werden.

Strömungsführungselemente 15. 1 und 15.2 können auch in offene Schlitze des das Wärmetauscherelement 1 bildenden Metallschaums oder eines mit Hohlkörpern gebildeten Wärmetauscherelements 1 eingeführt werden. Dabei sollten diese Schlitze zumindest an einer Seite des Metallschaums offen sein. Die Schlitze können parallel zu der Richtung ausgerichtet sein, die von der Seite, an der die elektronischen oder optoelektronischen Bauelemente 2 angeordnet sind, bis zur dieser gegenüberliegenden Seite ausgerichteten Richtung, ausgerichtet sein. Sie müssen dabei nicht von einer Seite bis zu der entsprechend gegenüberliegenden Seite ausgebildet, also nicht vollständig durch das Wärmetauscherelement 1 hindurch geführt sein.

Bei dem gezeigten Beispiel ist ein T-förmig ausgebildetes Strömungsführungselement 15.1 mit einem Steg 15.3 zwischen dem Zufluss 4 und dem Abfluss 5 innerhalb des Wärmetauscherelements 1 angeordnet. Das Temperierfluid muss dieses T-förmige Strömungsführungselement 15.1 umströmen. Zusätzlich sind dabei zwei weitere gerade und plattenförmige ausgebildete Strömungsführungselemente 15.2 im Wärmetauscherelement 1 angeordnet, die die Strömungsrichtung zusätzlich beeinflussen. Diese können auch im Gegensatz zur Darstellung konkav oder konvex gewölbt sein, um einen weicheren Übergang der Strömungsrichtung des Temperierfluids in diesen Bereichen zu ermöglichen. Eine gekrümmte oder gewölbte Form kann auch bei dem T-förmigen Strömungsführungselement 15.1 gewählt werden. Dies trifft insbesondere auf den quer stehenden Balken an der Spitze des T's zu.

## Patentansprüche

1. System zur Temperierung von elektronischen oder optoelektronischen Bauelementen oder Baugruppen, bei dem ein Temperierfluid zur Temperierung durch ein Wärmetauscherelement strömt,
wobei das Wärmetauscherelement (1) als ein offenporiger metallischer Körper ausgebildet ist und mindestens eine Oberfläche des Körpers, die in Richtung mindestens eines elektronischen oder optoelektronischen Bauelements (2) oder einer solchen Baugruppe ausgerichtet ist, fluiddicht ausgebildet oder mit einer für das Temperierfluid dichten Beschichtung versehen ist,
und
Sensoren, Aktoren oder elektrisch leitende Verbindungen innerhalb des Systems integriert vorhanden sind;
**dadurch gekennzeichnet, dass**
mindestens ein elektronisches oder optoelektronisches Bauelement (2) ein Deckelelement (13) bildet oder an einem Deckelelement (13) befestigt ist und
durch das Wärmetauscherelement, ausgehend von der Oberfläche an der mindestens ein elektronisches oder optoelektronisches Bauelement (2) angeordnet ist, bis zu der dieser Oberfläche gegenüberliegenden Oberfläche mindestens ein Versteifungselement (11) vorhanden ist, das innen hohl und mit dem Deckelelement (13) verbunden ist.

2. System nach Anspruch 1, **dadurch gekennzeichnet, dass** das Wärmetauscherelement (1) eine Porosität von mindestens 70 %, bevorzugt mindestens 90 % aufweist.

3. System nach Anspruch 1 oder 2, **dadurch gekennzeichnet, dass** das Wärmetauscherelement (1) aus einem Metallschaum oder mehreren metallischen Körpern, bevorzugt Hohlkörpern, die in loser Schüttung innerhalb eines Gehäuses aufgenommen oder stoffschlüssig miteinander verbunden sind, gebildet ist.

4. System nach einem der vorhergehenden Ansprüche, **dadurch gekennzeichnet, dass** sich die Porosität und/oder die Porengröße ausgehend von der Seite des Wärmetauscherelements (1), die in Richtung zu temperierender elektronischer oder optoelektronischer Bauelemente (2) weist, sukzessive oder kontinuierlich vergrößert.

5. System nach einem der vorhergehenden Ansprüche, **dadurch gekennzeichnet, dass** die für das Temperierfluid dichte Beschichtung mit einer Lötfolie gebildet ist.

6. System nach einem der vorhergehenden Ansprüche, **dadurch gekennzeichnet, dass** der Metallschaum oder die metallischen Körper aus einem Metall, das ausgewählt ist aus, Fe, Ni, Al und Cu oder einer Legierung davon, gebildet ist.

7. System nach einem der vorhergehenden Ansprüche, **dadurch gekennzeichnet, dass** zumindest der Oberflächenbereich des Wärmetauscherelements (1), der nicht in Richtung elektronischer oder optoelektronischer Bauelemente (2) weist, von einer thermischen Isolation (3) und/oder einem für elektromagnetische Strahlung transparenten Gehäuse (6) umschlossen ist.

8. System nach einem der vorhergehenden Ansprüche, **dadurch gekennzeichnet, dass** mindestens jeweils ein Zufluss (4) und ein Abfluss (5) für ein Temperierfluid und/oder ein Temperatursensor für eine Regelung des Volumenstroms des durch das Wärmetauscherelement (1) strömenden Temperier-fluids vorhanden ist/sind.

9. System nach einem der vorhergehenden Ansprüche, **dadurch gekennzeichnet, dass** ein Bereich vorhanden ist, der mit in eine polymere Matrix eingebetteten Hohlkörpern gebildet ist; wobei innerhalb dieses Bereichs Sensoren, Aktoren oder elektrisch leitende Verbindungen integriert angeordnet sind.

10. System nach einem der vorhergehenden Ansprüche, **dadurch gekennzeichnet, dass** am/im Wärmetauscherelement (1), einem thermischen Isolierelement (3), einem Gehäuse (6) und/oder einem Bereich Verstärkungselemente, bevorzugt in Form von Textilien oder Stäben, angeordnet sind.

11. System nach einem der vorhergehenden Ansprüche, **dadurch gekennzeichnet, dass** mindestens ein Lichtwellenleiter (9) als Sensor vorhanden ist.

12. System nach einem der vorhergehenden Ansprüche, **dadurch gekennzeichnet, dass** mindestens ein elektronisches oder optoelektronisches Bauelement (2) unmittelbar auf der Oberfläche des Wärmetauscherelements (1) oder der für das Temperierfluid dichten Beschichtung angeordnet ist.

13. System nach einem der vorhergehenden Ansprüche, **dadurch gekennzeichnet, dass** am Wärmetauscherelement (1) oder dem Gehäuse (6) für das Wärmetauscherelement (1) ein elektrischer Transformator (10) oder Gleichrichter angeordnet oder dort befestigt ist.

14. System nach einem der vorhergehenden Ansprüche, **dadurch gekennzeichnet, dass** im Wärmetauscherelement (1) mindestens ein Strömungsführungselement (15.1 und 15.2) zur Beeinflussung des Wegs, den das Temperierfluid im Wärmetauscherelement (1) zwischen Zufluss (4) und Abfluss (5) zurück legt, angeordnet ist.

15. System nach einem der vorhergehenden Ansprüche, **dadurch gekennzeichnet, dass** zur Ausrichtung oder Justierung elektronischer oder optoelektronischer Bauelemente mindestens ein Fixierelement (14) vorhanden ist.

## Claims

1. A system for the temperature control of electronic or optoelectronic components or assemblies, in which a temperature control fluid for temperature control flows through a heat exchanger element,
wherein the heat exchanger element (1) is configured as an open-pore metallic body; and wherein at least one surface of the body that is oriented in the direction of at least one electronic or optoelectronic component (2) or of such an assembly is formed as fluid-tight or is provided with a coating sealed for the temperature control fluid; and
wherein sensors, actuators, or electrically conductive connections are present integrated within the system,
**characterized in that**
at least one electronic or optoelectronic component (2) forms a cover element (13) or is fastened to cover element (13); and
**in that**, starting from the surface at which at least one electronic or optoelectronic component (2) is arranged, up to the surface disposed opposite this surface, at least one stiffening element (11) that is hollow at the interior and that is connected to the cover element (13) is present through the heat exchanger element.

2. A system in accordance with claim 1, **characterized in that** the heat exchanger element (1) has a porosity of at least 70%, preferably of at least 90%.

3. A system in accordance with claim 1 or claim 2, **characterized in that** the heat exchanger element (1) is formed from a metal foam or from a plurality of metallic bodies, preferably hollow bodies, that are loosely received within a housing or are connected to one another with material continuity.

4. A system in accordance with one of the preceding claims, **characterized in that** the porosity and/or the pore size is successively or continuously enlarged starting from the side of the heat exchanger element (1) that faces in the direction toward electronic or optoelectronic components (2) to be temperature controlled.

5. A system in accordance with one of the preceding claims, **characterized in that** the coating sealed for the temperature control fluid is formed by a solder film.

6. A system in accordance with one of the preceding claims, **characterized in that** the metal foam or the metallic bodies is formed from a metal that is selected from Fe, Ni, Al, and Cu or from an alloy thereof.

7. A system in accordance with one of the preceding claims, **characterized in that** at least the surface region of the heat exchanger element (1) that does not face in the direction of electronic or optoelectronic components (2) is surrounded by a thermal insulation (3) and/or by a housing (6) transparent for electromagnetic radiation.

8. A system in accordance with one of the preceding claims, **characterized in that** at least one respective inflow (4) and outflow (5) for a temperature control fluid and/or a temperature sensor for a regulation of the volume flow of the temperature control fluid flowing through the heat exchanger element (1) is/are present.

9. A system in accordance with one of the preceding claims, **characterized in that** a region is present that is formed by hollow bodies embedded in a polymer matrix, with sensors, actuators, or electrically conductive connections being arranged integrated within this region.

10. A system in accordance with one of the preceding claims, **characterized in that** reinforcement elements, preferably in the form of textiles or bars, are arranged at/in the heat exchanger element (1), at/in a thermal insulating element (3), at/in a housing (6), and/or at/in a region.

11. A system in accordance with one of the preceding claims, **characterized in that** at least one optical waveguide (9) is present as a sensor.

12. A system in accordance with one of the preceding claims, **characterized in that** at least one electronic or optoelectronic component (2) is arranged directly on the surface of the heat exchanger element (1) or on the coating sealed for the temperature control fluid.

13. A system in accordance with one of the preceding claims, **characterized in that** an electric transformer (10) or rectifier is arranged at the heat exchanger element (1) or at the housing (6) for the heat exchanger element (1) or is fastened there.

14. A system in accordance with one of the preceding claims, **characterized in that** at least one flow guidance element (15.1 and 15.2) for influencing the path the temperature control fluid covers in the heat exchanger element (1) between the inflow (4) and the outflow (5) is arranged in the heat exchanger element (1).

15. A system in accordance with one of the preceding claims, **characterized in that** at least one fixing element (14) is present for aligning or adjusting electronic or optoelectronic components.

## Revendications

1. Système de régulation de température de composants ou de sous-ensembles électroniques ou optoélectroniques, dans lequel un fluide de régulation de température s'écoule, pour la régulation de la température, à travers un élément échangeur thermique,
l'élément échangeur thermique (1) étant conçu comme un corps métallique à alvéoles ouvertes et au moins une surface du corps, qui est orientée en direction d'au moins un composant électronique ou optoélectronique (2) ou d'un tel sous-ensemble, étant conçue de manière étanche aux fluides ou étant munie d'un revêtement étanche au fluide de régulation de température, et
des capteurs, des actionneurs ou des liaisons électro-conductrices étant intégrés dans le système ;
**caractérisé en ce que**
au moins un composant électronique ou optoélectronique (2) forme un élément de couvercle (13) ou est fixé à un élément de couvercle (13) et
à travers l'élément échangeur thermique, à partir de la surface sur laquelle est disposé au moins un composant électronique ou optoélectronique (2), au moins un élément de rigidification (11) est présent jusqu'à la surface opposée à cette surface, qui est creux à l'intérieur et est relié avec l'élément de couvercle (13).

2. Système selon la revendication 1, **caractérisé en ce que** l'élément échangeur thermique (1) présente une porosité d'au moins 70 %, de préférence d'au moins 90 %.

3. Système selon la revendication 1 ou 2, **caractérisé en ce que** l'élément échangeur thermique (1) est constitué d'une mousse métallique ou de plusieurs corps métalliques, de préférence des corps creux, qui sont disposés en vrac ou reliés entre eux par liaison de matière à l'intérieur d'un boîtier.

4. Système selon l'une des revendications précédentes, **caractérisé en ce que** la porosité et/ou la taille des pores augmente de manière progressive ou continue à partir du côté de l'élément échangeur thermique (1), qui est orienté en direction des composants électroniques ou optoélectroniques (2) dont la température doit être régulée.

5. Système selon l'une des revendications précédentes, **caractérisé en ce que** le revêtement étanche au fluide de régulation de température est constitué d'une feuille de brasage.

6. Système selon l'une des revendications précédentes, **caractérisé en ce que** la mousse métallique ou les corps métalliques sont constitués d'un métal sélectionné parmi Fe, Ni, Al et Cu ou d'un alliage de ceux-ci.

7. Système selon l'une des revendications précédentes, **caractérisé en ce qu'**au moins la partie de surface de l'élément échangeur thermique (1) qui n'est pas orientée en direction des composants électroniques ou optoélectroniques (2) est entourée d'une isolation thermique (3) et/ou d'un boîtier (6) transparent pour les rayonnements électromagnétiques.

8. Système selon l'une des revendications précédentes, **caractérisé en ce qu'**au moins une admission (4) et une évacuation (5) pour un fluide de régulation de température et/ou un capteur de température pour une régulation du débit volumique du fluide de régulation de température s'écoulant à travers l'élément échangeur thermique (1) est/sont présent(s).

9. Système selon l'une des revendications précédentes, **caractérisé en ce qu'**une zone existe, qui est constituée de corps creux intégrés dans une matrice polymère ; des capteurs, actionneurs ou des liaisons électro-conductrices étant intégrés dans cette zone.

10. Système selon l'une des revendications précédentes, **caractérisé en ce que** sur/dans l'élément échangeur thermique (1), un élément d'isolation thermique (3), un boîtier (6) et/ou une zone, sont disposés des éléments de renfort, de préférence sous la forme de textiles ou de tiges.

11. Système selon l'une des revendications précédentes, **caractérisé en ce qu'**au moins une fibre optique (9) est présente en tant que capteur.

12. Système selon l'une des revendications précédentes, **caractérisé en ce qu'**au moins un composant électronique ou optoélectronique (2) est disposé directement sur la surface de l'élément échangeur thermique (1) ou sur le revêtement étanche au fluide de régulation de température.

13. Système selon l'une des revendications précédentes, **caractérisé en ce que**, sur l'élément échangeur thermique (1) ou sur le boîtier (6) pour l'élément échangeur thermique (1), est disposé ou fixé un transformateur électrique (10) ou un redresseur.

14. Système selon l'une des revendications précédentes, **caractérisé en ce que**, dans l'élément échangeur thermique (1), est disposé au moins un élément de guidage d'écoulement (15.1 et 15.2) pour influencer le trajet que parcourt le fluide de régulation de température dans l'élément échangeur thermique (1) entre l'admission (4) et l'évacuation (5).

15. Système selon l'une des revendications précédentes, **caractérisé en ce que**, pour l'orientation ou l'ajustement des composants électroniques ou optoélectroniques, au moins un élément de fixation (14) est présent.
